(19) 

Europäisches Patentamt

European Patent Office

Office européen des brevets

(11) **EP 2 533 293 A1**

(12) **EUROPEAN PATENT APPLICATION**

published in accordance with Art. 153(4) EPC

(43) Date of publication:
**12.12.2012 Bulletin 2012/50**

(21) Application number: **11737215.1**

(22) Date of filing: **01.02.2011**

(51) Int Cl.:
*H01L 29/786* (2006.01)   *C23C 14/08* (2006.01)
*C23C 14/34* (2006.01)   *H01L 21/363* (2006.01)
*H01L 21/368* (2006.01)

(86) International application number:
**PCT/JP2011/052016**

(87) International publication number:
**WO 2011/093506 (04.08.2011 Gazette 2011/31)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.02.2010 JP 2010020528**

(71) Applicant: **NEC Corporation
Tokyo 108-8001 (JP)**

(72) Inventors:
• **TAKECHI, Kazushige
Tokyo 108-8001 (JP)**
• **NAKATA, Mitsuru
Tokyo 108-8001 (JP)**

(74) Representative: **Töpken, Enno
Glawe. Delfs. Moll
Postbox 26 01 62
80058 Munich (DE)**

(54) **AMORPHOUS OXIDE THIN FILM, THIN FILM TRANSISTOR COMPRISING SAME, AND PROCESS FOR PRODUCTION OF THE THIN FILM TRANSISTOR**

(57)   A thin film transistor using an amorphous oxide thin film for an active layer, wherein: the amorphous oxide thin film includes, as main components, indium (In), oxygen (O), and a metal element (M) selected from the group consisting of silicon (Si), aluminum (Al), germanium (Ge), tantalum (Ta), magnesium (Mg) and titanium (Ti); an atomic ratio of M to In in this amorphous oxide thin film is 0.1 or more and 0.4 or less; and carrier density in the amorphous oxide thin film is $1 \times 10^{15}$ cm$^{-3}$ or more and $1 \times 10^{19}$ cm$^{-3}$ or less.

FIG. 4

**Description**

Technical Field

The present invention relates to an amorphous oxide thin film, a thin film transistor using the same, and a method for manufacturing the same.

Background Art

Transparent conductive oxide films including a film of ITO, which is a compound of indium, tin and oxygen, are widely used for various flat panel displays, photoelectric conversion elements, and the like because a sheet resistance of several Ω/sq. is obtained with a film thickness of about several hundreds nm, and the transmittance for visible light is high.

In recent years, studies on thin film transistors using amorphous oxide thin films, such as an In-Ga-Zn-O thin film, for the channel layer have begun. Such oxide thin films are formed by high ionic bonds and characterized by a small difference in electron mobility between the crystalline and amorphous states. Therefore, in the oxide thin films, relatively high electron mobility is obtained even in the amorphous state. In addition, the oxide thin films can be formed in the amorphous state at room temperature by using a spluttering method or the like, and therefore, studies on the formation of oxide thin film transistors on resin substrates, such as PET, have also been performed.

For such amorphous oxide thin films, in addition to the above In-Ga-Zn-O thin film, various thin films, such as those with a small number of constituent elements, such as an In-Zn-O thin film, and those using no rare metal, such as an Al-Sn-Zn-O thin film, have been examined.

Non Patent Literature 1 reports a thin film transistor using an In-Ga-Zn-O thin film.

Non Patent Literature 2 reports a thin film transistor using a Sn-Ga-Zn-O thin film in terms of using rare metals as few as possible.

Non Patent Literature 3 reports a thin film transistor using an Al-Zn-Si-O thin film as a rare metal-free system not using even Ga.

Non Patent Literature 4 reports a thin film transistor using a Zn-Sn-O thin film in terms of reducing the number of constituent elements.

Non Patent Literature 5 reports a thin film transistor using an In-X-O (X: B, Mg, Al, Si, Ti, Zn, Ga, Ge, Mo, or Sn) thin film as a result of searching for a series of materials.

Patent Literature 1 describes In-M-Zn-O (M is at least one of Ga, Al and Fe) and illustrates an amorphous oxide including at least one element of Sn, In and Zn (for example, In-Sn oxide), as an oxide semiconductor used as the channel layer of a thin film transistor. It is described that in this amorphous oxide, Sn may be replaced by $Sn_{1-x}Si_x$.

Citation List

Patent Literature

Patent Literature 1: JP2007-73705A

Non Patent Literature

Non Patent Literature 1: Nomura, et al., Nature, vol. 432, p. 488, (2004)
Non Patent Literature 2: Ogo, et al., physica status solidi (a), Vol. 205, p. 1920, (2008)
Non Patent Literature 3: Cho, et al., International Display Workshops 2008, Technical Digest, p. 1625, (2008)
Non Patent Literature 4: Chiang, et al., Applied Physics Letters, Vol. 86, p. 013503, (2005)
Non Patent Literature 5: Goyal, et al., Materials Research Society Symposium Proceeding, Vol. 1109, B04-03, (2009)

Summary of Invention

Technical Problem

Non Patent Literature 5 and Patent Literature 1 disclose a thin film transistor using a thin film in which one or two other elements are added to In oxide. However, these literatures do not disclose a suitable atomic ratio (composition ratio) of each element and carrier density in the thin film. Generally, it is known that in an oxide thin film, carriers are generated due to oxygen deficiency. Unless this carrier density is controlled in a suitable range to use an oxide thin film with the properties of a semiconductor, it is difficult to obtain good thin film transistor characteristics. For example, if the carrier density is too low, the oxide thin film is close to an insulator, and the on current is low. On the contrary, if the carrier density is too high, the oxide thin film is close to a metal, and the off current is high. In these circumstances, the on/off ratio is small, and good switching characteristics are not obtained. The carrier density suitable for a semiconductor is in the range of $1 \times 10^{15}$ cm$^{-3}$ or more and $1 \times 10^{19}$ cm$^{-3}$ or less. For such a carrier density, considering oxygen atom density in the thin film (the oxygen atom density is on the order of $1 \times 10^{22}$ cm$^{-3}$), the oxygen deficiency proportion is 0.1% or less, which is a slight amount. Therefore, for example, the report of Non Patent Literature 5 discloses the composition ratio range of 0.6 < In/(In + Si) < 0.9 in the In-Si-O thin film, but even in such a composition ratio range, the thin film does not function as the active layer of a thin film transistor if the oxygen deficiency proportion exceeds 0.1% and the carrier density is too high.

The present inventors have clarified the above problem and found that in order to solve this problem, it is necessary to control oxygen deficiency (that is, carrier density) in a trace amount of several tens ppm to 0.1% or less, in addition to the control of the composition ratio of the oxide thin film. In addition, the present inventors have found that such control of oxygen deficiency density in a trace amount is difficult only by changing the composition ratio of oxygen atoms in the target, and it is important to suitably control the oxygen partial pressure of the atmosphere gas during film formation.

It is an object of the present invention to provide an amorphous oxide thin film excellent in electrical characteristics, a high performance thin film transistor, and a method for manufacturing the same.

Solution to Problem

One aspect of the present invention provides
a thin film transistor using an amorphous oxide thin film for an active layer, wherein:
the amorphous oxide thin film includes, as main components,
indium (In),
oxygen (O), and
a metal element (M) selected from the group consisting of silicon (Si), aluminum (Al), germanium (Ge), tantalum (Ta), magnesium (Mg) and titanium (Ti);
an atomic ratio of M to In in the amorphous oxide thin film is 0.1 or more and 0.4 or less; and
carrier density in the amorphous oxide thin film is $1 \times 10^{15}$ cm$^{-3}$ or more and $1 \times 10^{19}$ cm$^{-3}$ or less.

Another aspect of the present invention provides
an amorphous oxide thin film including, as main components, indium (In), oxygen (O), and a metal element (M) selected from the group consisting of silicon (Si), aluminum (Al), germanium (Ge), tantalum (Ta), magnesium (Mg), and titanium (Ti), wherein an atomic ratio of M to In is 0.1 or more and 0.4 or less, and
carrier density is $1 \times 10^{15}$ cm$^{-3}$ or more and $1 \times 10^{19}$ cm$^{-3}$ or less.

Another aspect of the present invention provides
a method for manufacturing the above thin film transistor, the method including performing sputtering under an atmosphere of a mixed gas including a noble gas and oxygen, satisfying the following conditional formula of a gas pressure ratio:

$$0.05 < \text{oxygen gas partial pressure/(noble gas partial pressure + oxygen gas partial}$$

$$\text{pressure}) < 0.25,$$

to form the amorphous oxide thin film.

Another aspect of the present invention provides a method for manufacturing the above thin film transistor, including:

applying or printing a liquid including In, the metal element (M), and O on a substrate, and
performing heat treatment at 150°C or more, such that carbon density is $1 \times 10^{19}$ cm$^{-3}$ or less, to solidify the liquid to form the amorphous oxide thin film.

Advantageous Effects of Invention

The present invention can provide an amorphous oxide thin film excellent in electrical characteristics, a high performance thin film transistor, and a method for manufacturing the same.

Brief Description of Drawings

[Figure 1] Figure 1 is a cross-sectional view showing a thin film transistor (bottom gate staggered type) according to a first exemplary embodiment.
[Figure 2] Figure 2 is a cross-sectional view showing a thin film transistor (top gate staggered type) according to a second exemplary embodiment.
[Figure 3] Figure 3 is a diagram showing the transfer characteristics of thin film transistors.
[Figure 4] Figure 4 is a diagram showing the composition ratio dependence of the carrier density of oxide thin films.
[Figure 5] Figure 5 is a diagram showing the transfer characteristics of thin film transistors.

Description of Embodiments

An exemplary embodiment can provide an amorphous oxide semiconductor thin film preferred for the active layers of thin film transistors. Controlling the type and ratio of the composition of and the carrier density of the amorphous oxide semiconductor thin film can provide a thin film transistor having good switching characteristics with an on/off ratio of five digits or more. In addition, specifying the type of the composition of the amorphous oxide semiconductor thin film can provide a high performance thin film transistor at low cost.

In the amorphous oxide semiconductor thin film according to the exemplary embodiment, the use of rare metals can be suppressed, or the number of elements in the thin film can be as small as possible, and the carrier density in the thin film is suitably controlled. For example, an amorphous oxide semiconductor thin film is provided in which an appropriate amount of a silicon oxide component or an aluminum oxide component is added to an indium oxide component, and the carrier density is controlled in the range of $1 \times 10^{15}$ cm$^{-3}$ or more and $1 \times 10^{19}$ cm$^{-3}$ or less. This carrier density can be controlled at $1 \times 10^{16}$ cm$^{-3}$ or more, can be further controlled at $1 \times 10^{17}$ cm$^{-3}$ or more, and can also be controlled at $1.5 \times 10^{18}$ or less.

Specifically, this semiconductor thin film can be formed by sputtering using an In-Si-O target or an In-Al-O target with a controlled element composition ratio. At this time, the value of oxygen gas partial pressure/(argon gas partial pressure + oxygen gas partial pressure) is controlled at a value larger than 0.05 and smaller than 0.25. This gas pressure ratio can be controlled at 0.2 or less and can be further controlled at 0.15 or less.

This semiconductor thin film can be obtained by applying or printing a liquid including at least In, Si and O elements, or a liquid including In, Al and O elements, and then performing heat treatment at 150°C or more.

In a thin film transistor using this semiconductor thin film for an active layer, the level density at an energetically deep position in the band gap of the amorphous oxide semiconductor thin film near the interface forming the semiconductor thin film/insulator thin film interface is in the range of $1 \times 10^{15}$ cm$^{-3}$eV$^{-1}$ to $1 \times 10^{16}$ cm$^{-3}$eV$^{-1}$. Therefore, if the carrier density in this semiconductor thin film is smaller than $1 \times 10^{15}$ cm$^{-3}$, the subthreshold characteristics (the ease of increase in drain current with respect to gate voltage at the time of transition from the off state to the on state) of the thin film transistor using such an interface worsen, and sharp on/off characteristics may not be obtained. In addition, if the carrier density exceeds $1 \times 10^{19}$ cm$^{-3}$, carriers in the semiconductor thin film cannot be depleted with practical gate insulating film thickness and gate voltage, and as a result, good off characteristics are not obtained. Therefore, the use of an amorphous oxide semiconductor thin film with a carrier density of $1 \times 10^{15}$ cm$^{-3}$ or more and $1 \times 10^{19}$ cm$^{-3}$ or less is

important to achieve good thin film transistor characteristics. This carrier density can be controlled at $1 \times 10^{16}$ cm$^{-3}$ or more, can be further controlled at $1 \times 10^{17}$ cm$^{-3}$ or more, and can also be controlled at $1.5 \times 10^{18}$ or less.

Instead of Si or Al forming this amorphous oxide semiconductor thin film, other elements can be used. In other words, this semiconductor thin film can include a metal element (M) selected from the group consisting of silicon (Si), aluminum (Al), germanium (Ge), tantalum (Ta), magnesium (Mg) and titanium (Ti).

The atomic ratio of this metal element (M) to In is preferably 0.1 or more and 0.4 or less.

This amorphous oxide semiconductor thin film can be formed by performing sputtering, using a target including In, the metal element (M) and O, under an atmosphere of a mixed gas including a noble gas and oxygen, satisfying the following conditional formula of a gas pressure ratio:

$$0.05 < \text{oxygen gas partial pressure/(noble gas partial pressure + oxygen gas partial}$$

$$\text{pressure)} < 0.25.$$

The gas pressure ratio in this conditional formula can be set at 0.2 or less and can be further set at 0.15 or less.

In addition, this amorphous oxide semiconductor thin film can be formed by applying or printing a liquid containing In, the metal element (M) and O on a substrate, and then performing heat treatment at 150°C or more.

This amorphous oxide semiconductor thin film may be a thin film further including tin (Sn) in which the atomic ratio of Sn to In is 0.03 or more and 0.5 or less.

This amorphous oxide semiconductor thin film can be formed by performing sputtering, using a target including In, Sn, the metal element (M) and O, under an atmosphere of a mixed gas including a noble gas and oxygen, satisfying the following conditional formula of a gas pressure ratio:

$$0.05 < \text{oxygen gas partial pressure/(noble gas partial pressure + oxygen gas partial}$$

$$\text{pressure)} < 0.25.$$

The gas pressure ratio in this conditional formula can be set at 0.2 or less and can be further set at 0.15 or less.

In addition, this amorphous oxide semiconductor thin film can be formed by applying or printing a liquid including In, the metal element (M) and O on a substrate, and then performing heat treatment at 150°C or more to solidify the liquid. This heat treatment is performed so that the carbon density in the film is $1 \times 10^{19}$ cm$^{-3}$ or less. As this liquid, a liquid that includes a solvent and a compound including at least any of an In element, the metal element (M) and an O element can be used. This liquid can include the In element, the metal element (M) and the O element derived from the compound included in the liquid.

The exemplary embodiments will be further described below with reference to the drawings.

First Exemplary Embodiment

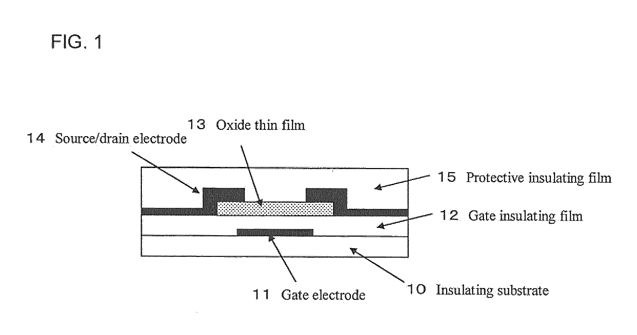

Figure 1 is a cross-sectional view showing a thin film transistor (bottom gate staggered type) according to a first exemplary embodiment. A gate electrode 11 is formed on an insulating substrate 10, such as plastic or glass, and a gate insulating film 12 is formed thereon. An In-Sn-Si-O thin film 13 is further formed thereon by an RF sputtering method.

In the formation of this oxide thin film, a target made of In-Sn-Si-O with a composition ratio in which the average atomic ratio of Si to In is 0.1 or more and 0.4 or less and the average atomic ratio of Sn to In is 0.03 or more and 0.5 or less is used. In this case, a target with a composition ratio represented by approximately $\text{In}_{10}\text{Sn}_y\text{Si}_x\text{O}_z$ depending on the atomic ratio of Si, can be used.

In addition, by performing sputtering under an atmosphere of a mixed gas including a noble gas and oxygen, satisfying the following conditional formula of a gas pressure ratio:

$$0.05 < \text{oxygen gas partial pressure/(noble gas partial pressure + oxygen gas partial}$$

$$\text{pressure)} < 0.25,$$

the average carrier density in the oxide thin film can be controlled in the range of $1 \times 10^{15}$ cm$^{-3}$ or more and $1 \times 10^{19}$ cm$^{-3}$ or less. At this time, sputtering can be performed under an atmosphere of a mixed gas including a noble gas and oxygen in which the gas flow rate ratio satisfies the following conditional formula:

$$0.05 < \text{oxygen gas flow rate}/(\text{noble gas flow rate} + \text{oxygen gas flow rate}) < 0.25.$$

Here, as the noble gas, helium, neon, argon, krypton, xenon, or the like can be used.

The In-Sn-Si-O thin film formed by sputtering in this manner has the same composition ratio as the sputtering target. In other words, in this oxide thin film, Si atoms are spatially distributed in the film with the average number (x) of Si atoms in the range of 1 to 4 with respect to 10 In atoms, and Sn atoms are spatially distributed in the film with the average number (y) of Sn atoms in the range of 0.3 to 5 with respect to 10 In atoms. At this time, the average number (z) of O atoms is $z = 2x + 2y + 15$ in terms of a stoichiometric ratio, but, actually, O atoms are distributed in the range of $2x + 2y + 8 < z < 2x + 2y + 22$. When the X-ray diffraction pattern of an oxide thin film with such a composition ratio was measured, no diffraction peak was seen, and it was confirmed that the oxide thin film was amorphous.

The film thickness of this oxide thin film is preferably in the range of 10 to 200 nm. If the film thickness is thinner than 10 nm, it is difficult to control the film thickness with high precision. In addition, with a film thickness thicker than 200 nm, it is difficult to control carrier density at the top channel side interface by the electric field of the bottom gate, and good off characteristics may not be obtained.

Source-drain electrodes 14 are formed on both sides of this oxide thin film. Then, a protective insulating film 15 is formed.

Here, in order to further enhance the stability of thin film transistor characteristics, it is desired that the formation of the gate insulating film 12 and the formation of the In-Sn-Si-O thin film 13 are continuously performed without exposure to the air during the formation. Specifically, it is desired to form films using a film formation apparatus in which a substrate can be conveyed in a vacuum between a sputtering chamber for forming a gate insulating film and a sputtering chamber for forming an oxide thin film.

Such a thin film transistor can achieve good electrical characteristics with an on/off ratio of six digits or more, a field-effect mobility of about 10 $cm^2V^{-1}s^{-1}$, and a threshold voltage of about 1 V.

Here, when an In-Sn-Si-O thin film is formed by sputtering under the condition of oxygen gas partial pressure/(noble gas partial pressure + oxygen gas partial pressure) < 0.05, the carrier density in the thin film is larger than $1 \times 10^{19}$ $cm^{-3}$, and the thin film transistor does not show good off characteristics. On the contrary, when an In-Sn-Si-O thin film is formed by sputtering under the condition of 0.25 < oxygen gas partial pressure/(noble gas partial pressure + oxygen gas partial pressure), the carrier density in the thin film is smaller than $1 \times 10^{15}$ $cm^{-3}$, and the thin film transistor does not show good on characteristics.

In addition, when an In-Sn-Si-O thin film is formed using a target in which the average atomic ratio of Si to In is less than 0.1, the thin film transistor does not show good off characteristics. When an In-Sn-Si-O thin film is formed using a target in which the average atomic ratio of Si to In is larger than 0.4, the thin film transistor does not show good on characteristics.

In the first exemplary embodiment, it is desired to use a silicon oxide film as the gate insulating film. This silicon oxide film is obtained by reactively sputtering a silicon target under an atmosphere of a mixed gas of argon and oxygen. The silicon oxide film may be formed by plasma CVD or thermal CVD using silane gas. Since the In-Sn-Si-O thin film, which is the active layer, and the silicon oxide film, which is the gate insulating film, have the same Si-O bond in the films, good interface characteristics are easily obtained. However, the gate insulating film is not limited to the silicon oxide film and may be an oxide film or a nitride film, such as a silicon nitride film, an aluminum oxide film, or a tantalum oxide film, or a laminated film of these films.

In the first exemplary embodiment, the In-Sn-Si-O film is used as the active layer, but an In-Sn-Al-O film, an In-Sn-Ge-O film, an In-Sn-Ta-O film, an In-Sn-Mg-O film, an In-Sn-Ti-O film, or the like can be used. Also in these cases, by suitably controlling the composition of targets and gas partial pressure, carrier density suitable for a semiconductor can be achieved.

Second Exemplary Embodiment

A thin film transistor (bottom gate staggered type) according to a second exemplary embodiment will be described with reference to Figure 1.

A gate electrode 11 is formed on an insulating substrate 10, such as plastic or glass, and a gate insulating film 12 is formed thereon. An In-Si-O thin film ($In_{10}Si_yO_z$ thin film) 13 is further formed thereon by an RF sputtering method.

In the formation of this oxide thin film, a target made of In-Si-O with a composition ratio in which the average atomic ratio of Si to In is 0.1 or more and 0.4 or less (a composition in the range of $In_{10}Si_1O_{17}$ to $In_{10}Si_4O_{23}$) is used. In this case, a target with a composition ratio represented by approximately $In_{10}Si_xO_{2x+15}$ depending on the atomic ratio of Si can be used.

In addition, by performing sputtering under an atmosphere of a mixed gas including a noble gas and oxygen, satisfying the following conditional formula of a gas flow rate ratio during sputtering:

$$0.05 < \text{oxygen gas flow rate}/(\text{noble gas flow rate} + \text{oxygen gas flow rate}) < 0.25,$$

the average carrier density in the oxide thin film can be controlled in the range of $1 \times 10^{15}$ cm$^{-3}$ or more and $1 \times 10^{19}$ cm$^{-3}$ or less. A gas flow rate ratio is equivalent to a gas partial pressure ratio. In other words, the above conditional formula of a flow rate ratio is equivalent to the following conditional formula of a gas pressure ratio:

$$0.05 < \text{oxygen gas partial pressure}/(\text{noble gas partial pressure} + \text{oxygen gas partial}$$

$$\text{pressure}) < 0.25.$$

Here, as the noble gas, helium, neon, argon, krypton, xenon, or the like can be used.

The $In_{10}Si_yO_z$ thin film formed by sputtering in this manner has substantially the same composition ratio as the sputtering target. In other words, in this oxide thin film, Si atoms are spatially distributed in the film with the average number (x) of Si atoms in the range of 1 to 4 with respect to 10 In atoms. At this time, the average number (z) of O atoms is $z = 2x + 15$ in terms of a stoichiometric ratio, but, actually, O atoms are distributed in the range of $2x + 8 < z < 2x + 22$. When the X-ray diffraction pattern of an oxide thin film with such a composition ratio was measured, no diffraction peak was seen, and it was confirmed that the oxide thin film was amorphous.

The film thickness of this oxide thin film is preferably in the range of 10 to 200 nm. If the film thickness is thinner than 10 nm, it is difficult to control the film thickness with high precision. In addition, with a film thickness thicker than 200 nm, it is difficult to control carrier density at the top channel side interface by the electric field of the bottom gate, and good off characteristics may not be obtained.

Source-drain wirings 14 are formed on both sides of this oxide thin film. Then, a protective insulating film (passivation insulating film) 15 is formed.

Here, in order to further enhance the stability of thin film transistor characteristics, it is desired that the formation of the gate insulating film 12 and the formation of the In-Si-O thin film 13 are continuously performed without exposure to the air during the formation. Specifically, it is desired to form films using a film formation apparatus in which a substrate can be conveyed in a vacuum between a sputtering chamber for forming a gate insulating film and a sputtering chamber for forming an oxide thin film.

Such a thin film transistor can achieve good electrical characteristics with an on/off ratio of six digits or more, a field-effect mobility of about 10 cm$^2$V$^{-1}$s$^{-1}$, and a threshold voltage of about 1 V.

Here, when an In-Si-O thin film is formed by sputtering under the condition of oxygen gas partial pressure/ (noble gas partial pressure + oxygen gas partial pressure) < 0.05, the carrier density in the thin film is larger than $1 \times 10^{19}$ cm$^{-3}$, and the thin film transistor does not show good off characteristics, with an on/off ratio of two digits or less. On the contrary, when an In-Si-O thin film is formed by sputtering under the condition of 0.25 < oxygen gas partial pressure/(noble gas partial pressure + oxygen gas partial pressure), the carrier density in the thin film is smaller than $1 \times 10^{15}$ cm$^{-3}$, and the thin film transistor does not show good on characteristics, with an on/off ratio of two digits or less.

In addition, when an In-Si-O thin film is formed using a target in which the average atomic ratio of Si to In is less than 0.1, the thin film transistor does not show good off characteristics. When an In-Si-O thin film is formed using a target in which the average atomic ratio of Si to In is larger than 0.4, the thin film transistor does not show good on characteristics.

In the second exemplary embodiment, it is desired to use a silicon oxide film as the gate insulating film. This silicon oxide film is obtained by reactively sputtering a silicon target under an atmosphere of a mixed gas of argon and oxygen. The silicon oxide film may be formed by plasma CVD or thermal CVD using silane gas. Since the In-Si-O thin film, which is the active layer, and the silicon oxide film, which is the gate insulating film, have the same Si-O bond in the films, good interface characteristics are easily obtained, and the interface level density can be reduced to $1 \times 10^{12}$ cm$^{-3}$ or less. However, the gate insulating film is not limited to the silicon oxide film and may be an oxide film or a nitride film, such as a silicon nitride film, an aluminum oxide film, or a tantalum oxide film, or a laminated film of these films.

In the second exemplary embodiment, the In-Si-O film is used as the active layer, but an In-Al-O film, an In-Ge-O film, an In-Ta-O film, an In-Mg-O film, an In-Ti-O film, or the like can be used. Also in these cases, by suitably controlling the composition of the target and gas partial pressure, carrier density suitable for a semiconductor can be achieved.

Third Exemplary Embodiment

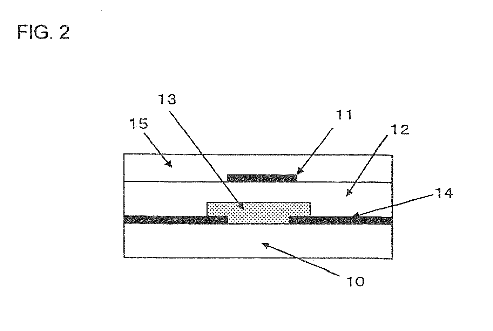

Figure 2 is a cross-sectional view showing a thin film transistor (top gate staggered type) according to a third exemplary embodiment. Source-drain electrodes 14 are formed on an insulating substrate 10, such as plastic or glass. An In-Al-O thin film 13 is formed by an RF sputtering method between the source-drain electrodes so as to overlap these electrodes on both sides.

In the formation of this oxide thin film, a target made of In-Al-O with a composition ratio in which the average atomic ratio of Al to In is 0.1 or more and 0.4 or less is used. In this case, a target with a composition ratio represented by approximately $In_{10}Al_xO_{1.5x+15}$ depending on the atomic ratio of Al can be used.

In addition, by performing sputtering under an atmosphere of a mixed gas including a noble gas and oxygen, satisfying the following conditional formula of a gas pressure ratio:

$$0.05 < \text{oxygen gas partial pressure/(noble gas partial pressure + oxygen gas partial pressure)} < 0.25,$$

the average carrier density in the oxide thin film is controlled in the range of $1 \times 10^{15}$ cm$^{-3}$ or more and $1 \times 10^{19}$ cm$^{-3}$ or less. Here, as the noble gas, helium, neon, argon, krypton, xenon, or the like can be used.

The In-Al-O thin film 13 formed by sputtering in this manner has substantially the same composition ratio as the sputtering target. In other words, in this oxide thin film, Al atoms are spatially distributed in the film with the average number (x) of Al atoms in the range of 1 to 4 with respect to 10 In atoms. When the X-ray diffraction pattern of an oxide thin film with such a composition ratio was measured, no diffraction peak was seen, and it was confirmed that the oxide thin film was amorphous.

The film thickness of this oxide thin film is preferably in the range of 10 to 200 nm. If the film thickness is thinner than 10 nm, it is difficult to control the film thickness with high precision. In addition, with a film thickness thicker than 200 nm, it is difficult to control carrier density at the channel side interface by the electric field of the gate, and good off characteristics may not be obtained.

A gate insulating film 12 is formed on the In-Si-O thin film 13. Here, in order to further enhance the stability of thin film transistor characteristics, it is desired that the formation of the In-Al-O thin film 13 and the gate insulating film 12 is continuously performed without exposure to the air during the formation.

A gate electrode 11 is formed on the gate insulating film 12, and then, a protective insulating film 15 is formed.

Such a thin film transistor can achieve good electrical characteristics with an on/off ratio of six digits or more, a field-effect mobility of about 5 cm$^2$V$^{-1}$s$^{-1}$, and a threshold voltage of about 1 V.

Here, when an In-Al-O thin film is formed by sputtering under the condition of oxygen gas partial pressure/ (noble gas partial pressure + oxygen gas partial pressure) < 0.05, the carrier density in the thin film is larger than $1 \times 10^{19}$ cm$^{-3}$, and the thin film transistor does not show good off characteristics. On the contrary, when an In-Al-O thin film is sputtered under the condition of 0.25 < oxygen gas partial pressure/(noble gas partial pressure + oxygen gas partial pressure), the carrier density in the thin film is smaller than $1 \times 10^{15}$ cm$^{-3}$, and the thin film transistor does not show good on characteristics.

In addition, when an In-Al-O thin film is formed using a target in which the average atomic ratio of Al to In is less than 0.1, the thin film transistor does not show good off characteristics. When an In-Al-O thin film is formed using a target in which the average atomic ratio of Al to In is larger than 0.4, the thin film transistor does not show good on characteristics.

In the third exemplary embodiment, it is desired to use an aluminum oxide film as the gate insulating film. Since the In-Al-O thin film, which is the active layer, and the aluminum oxide film, which is the gate insulating film, have the same Al-O bond in the films, good interface characteristics are easily obtained. However, the gate insulating film is not limited to the aluminum oxide film and may be an oxide film or a nitride film, such as a silicon nitride film, a silicon oxide film, or a tantalum oxide film, or a laminated film of these films.

In addition, in the third exemplary embodiment, the In-Al-O film is used as the active layer, but an In-Si-O film, an In-Ge-O film, an In-Ta-O film, an In-Mg-O film, an In-Ti-O film, or the like can be used. Also in these cases, by suitably controlling the composition of targets and gas partial pressure, carrier density suitable for a semiconductor can be achieved.

In addition, the number of constituent elements of the oxide thin film is not limited to 3 and may be 4. Specifically, an In-Sn-Al-O film can be used for the active layer. In this case, it is important that the average atomic ratio of Al to In is 0.1 or more and 0.4 or less, and the average atomic ratio of Sn to In is 0.03 or more and 0.5 or less, and further, the average carrier density in this amorphous oxide thin film is $1 \times 10^{15}$ cm$^{-3}$ or more and $1 \times 10^{19}$ cm$^{-3}$ or less.

Other Exemplary Embodiments

In the above first exemplary embodiment, second exemplary embodiment, and third exemplary embodiment, a sputtering method, which is a vacuum process, is used for the formation of the In-Sn-Si-O thin film, the In-Si-O thin film, and the In-Al-O thin film, respectively. In order to achieve further cost reduction, these thin films may be formed by a film formation method using a solution solidification process.

In this film formation method, a liquid including at least In, Si, and O elements (a raw material solution) is applied or printed, and then, heat treatment is performed at a temperature of 150°C or more. As the raw material solution, a liquid including a solvent and compounds including at least any one of In, Si, and O elements can be used. For example, as the liquid including at least In, Si, and O elements, a liquid including a solvent and a compound including In, such as indium chloride, a compound including Si and O, such as siloxane can be used. Thus, an In-Si-O thin film with an average carrier density of $1 \times 10^{15}$ cm$^{-3}$ or more and $1 \times 10^{19}$ cm$^{-3}$ or less and a carbon density of $1 \times 10^{19}$ cm$^{-3}$ or less can be formed. It is possible to use a method of spin-coating this raw material solution to form an In-Si-O thin film on the entire surface of a substrate and then patterning the film in a desired shape, a method of drawing a pattern of an In-Si-O thin film in a desired shape by an ink-jet method using this raw material solution, or the like. By performing heat treatment at 150°C or more in an atmosphere including oxygen after applying or printing this raw material solution, the applied or printed thin film is solidified, and carbon in the film, which is derived from organic substances included in the raw material solution, is released out of the film as carbon dioxide, and thus, the carbon density in the film can be $1 \times 10^{19}$ cm$^{-3}$ or less. An In-Al-O thin film can also be formed by a similar film formation method. In this case, as compounds including at least any one of In, Al, and O elements, a compound including In, such as indium chloride, a compound including Al, such as aluminum chloride, and a compound including Al and O, such as aluminate, can be used. Three compounds, indium chloride, aluminum chloride and aluminate, may be used in combination, or two compounds, indium chloride and aluminate, may be used in combination.

The optical band gap of the oxide thin films with a controlled composition ratio and controlled carrier density according to the first, second, and second exemplary embodiments and other exemplary embodiments changes in the range of 3.0 eV to 3.8 eV. Therefore, the oxide thin films are substantially transparent to visible light, and on the other hand absorb ultraviolet rays to improve the electrical conductivity of the thin films. Particularly in the carrier density range specified in the present invention, the oxide thin films have semiconducting electrical conductivity, and irradiating the oxide thin films with ultraviolet light can increase carrier density and increase electrical conductivity by several digits. Utilizing this feature, the oxide thin films according to the exemplary embodiments can be used not only for the active layers of thin film transistors but also for ultraviolet sensor applications. In addition, by arbitrarily controlling the composition ratio of Si or Al to control the electrical conductivity (that is, resistivity) of the oxide thin films, the oxide thin films can also be utilized as the transparent resistance elements of thin film devices.

Examples

Example 1

The thin film transistor of Example 1 will be described with reference to Figure 1.

A glass substrate was used as an insulating substrate 10, and a film of ITO (indium tin oxide) was formed on this substrate by a sputtering method. Then, patterning was performed using a photolithography technique and an etching technique to form a gate electrode 11 of a predetermined shape.

Then, a silicon oxide film (thickness: 200 nm) was formed as a gate insulating film 12 by a sputtering method. This silicon oxide film was formed by performing sputtering under an atmosphere of a mixed gas of argon and oxygen, using a silicon target that was not doped with an impurity.

Then, an In-Sn-Si-O thin film (thickness: 30 nm) was formed by a sputtering method and then patterned in a predetermined shape to form an active layer 13 made of this oxide thin film. The film formation temperature was room temperature. As the sputtering targets, two, an ITO target (a target fabricated by mixing $In_2O_3$ and $SnO_2$ at a molar ratio of 5:1) and a silicon target, were used. The In-Sn-Si-O thin film was formed by a simultaneous sputtering method in which electric power was simultaneously applied to these two targets. Here, the electric power applied to the ITO target was kept constant, and only the electric power applied to the silicon target was changed. The total gas pressure during the film formation was set at 0.5 Pa, and the flow rate ratio of argon gas to oxygen gas was set at 9:1. In other words, sputtering was performed under an atmosphere of a mixed gas of argon and oxygen with a gas pressure ratio (oxygen gas partial pressure/(argon gas partial pressure + oxygen gas partial pressure)) of 0.1. The Si composition ratio in the In-Sn-Si-O thin film formed in this manner changed depending on the value of the electric power applied to the silicon target.

This In-Sn-Si-O thin film was patterned in a predetermined shape to form the active layer 13, and then, an ITO film was formed and patterned in a predetermined shape to form source-drain electrodes 14.

Then, a silicon oxide film was formed as a protective insulating film 15 by a room temperature sputtering method, and a predetermined contact hole was formed to complete a thin film transistor structure. In order to obtain stable electrical characteristics, finally, heat treatment (annealing) was performed in the air atmosphere at 300°C for 1 hour.

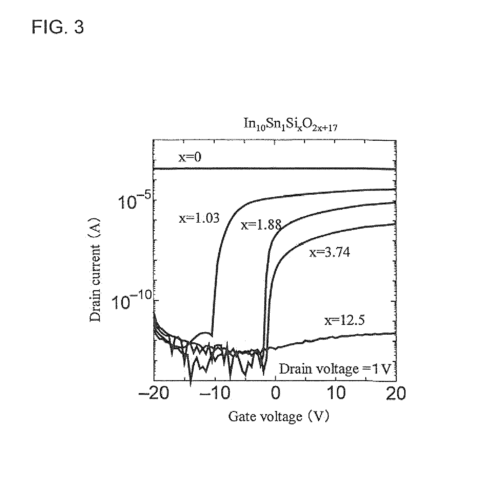

Figure 3 shows changes in thin film transistor characteristics when the Si composition ratio in the In-Sn-Si-O thin film changes. Here, as the indicator of the composition ratio of the formed In-Sn-Si-O film, x represented by the stoichiometric ratio composition $In_{10}Sn_1Si_xO_{2x+17}$ is used. The Sn composition ratio is 1 with respect to an In composition ratio of 10 because of the atomic ratio of Sn to In in the ITO target as described above. When x is 1 or more and 4 or less (that is, the average atomic ratio of Si to In is 0.1 or more and 0.4 or less), good switching characteristics are seen. On the other hand, when x is smaller than 1, off characteristics are not shown. On the contrary, when x is larger than 4, on characteristics are not shown. This experimental data shows that it is important to control the average atomic ratio of Si to In at 0.1 or more and 0.4 or less.

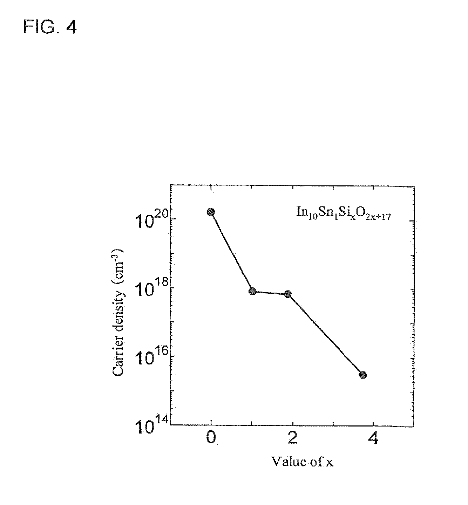

Figure 4 shows changes in average carrier density in the In-Sn-Si-O film with respect to the value of the above x. The carrier density of an oxide thin film in the present invention is electron density, and its origin is equivalent to oxygen deficiency density in the thin film. Here, the carrier density was obtained by general Hall effect measurement. When x is 1 or more and 4 or less, the carrier density is in the region of $1 \times 10^{15}$ cm$^{-3}$ or more and $1 \times 10^{19}$ cm$^{-3}$ or less. When x is smaller than 1, the carrier density is as high as about $1 \times 10^{20}$ cm$^{-3}$. When x is larger than 4, the carrier density is smaller than $1 \times 10^{15}$ cm$^{-3}$. Hence, by setting the average atomic ratio of Si to In at 0.1 or more and 0.4 or less, the average oxygen deficiency density in the In-Sn-Si-O thin film can be controlled in the range of $1 \times 10^{15}$ cm$^{-3}$ or more and $1 \times 10^{19}$ cm$^{-3}$ or less.

The carrier density can also be measured by scanning capacitance microscopy (SCM). In this case, a carrier density distribution in the cross-sectional direction of the thin film (the direction perpendicular to the substrate plane) can be measured. It is important that the carrier density distribution in the cross-sectional direction of the thin film is in the range of $1 \times 10^{15}$ cm$^{-3}$ or more and $1 \times 10^{19}$ cm$^{-3}$ or less. In the case of Hall effect measurement, the carrier density is estimated as an average value for the entire thin film. Therefore, even if the average carrier density estimated in Hall effect measurement is in the region of $1 \times 10^{15}$ cm$^{-3}$ or more and $1 \times 10^{19}$ cm$^{-3}$ or less, good transistor characteristics may not be exhibited when a region with a carrier density exceeding $1 \times 10^{19}$ cm$^{-3}$ is localized, for example, only in the ultrathin portion of the oxide thin film in the vicinity of the interface between the oxide thin film and the gate insulating film.

As seen from Figure 3 and Figure 4, when a composition ratio of x = 1.88 and a carrier density of $6.7 \times 10^{17}$ cm$^{-3}$ were satisfied, good electrical characteristics with a turn-on voltage (gate voltage at which drain current starts to increase suddenly from the off region) around 0 V, the largest on/off ratio, a field-effect mobility of about 5 cm$^2$V$^{-1}$s$^{-1}$, and a threshold voltage of about 1 V were achieved. At this time, the In-Sn-Si-O thin film was formed at room temperature under a gas atmosphere (total gas pressure: 0.5 Pa) satisfying oxygen gas partial pressure/(argon gas partial pressure + oxygen gas partial pressure) = 0.1 while an electric power of 75 W was applied to the above-described ITO target (4-inch size) and an electric power of 113 W was applied to the silicon target (4 inch size). The composition ratio of the entire thin film measured by the Rutherford backscattering method was In:Sn:Si:O = 10:1:1.88:20.7.

In addition, as shown in Figure 3, in all cases of x = 1.03, 1.88, and 3.74, the turn-on voltage is slightly lower than 0 V, and the so-called depletion type behavior is shown. In terms of applications, enhancement type (an operation in which the turn-on voltage is on the positive side of 0 V) behavior may also be needed. In such a case, it is also possible to provide the enhancement type by controlling the fixed charge density in the gate insulating film and the work function of the gate metal.

In the above Example, heat treatment (annealing) was performed after the completion of the thin film transistor structure, but it is also possible to add heat treatment during the manufacture of the thin film transistor, for example, immediately after the formation of the In-Sn-Si-O thin film. Particularly in the In-Sn-Si-O thin film formed by room temperature-sputtering, components derived from water (an OH group and the like) may be included. If such components are included, the electrical characteristics of the thin film transistor may be unstable. It is possible to release such water-derived components out of the film by performing heat treatment after the completion of the thin film transistor structure. But, after the completion of the thin film transistor structure, a thin film, such as the protective insulating film, is formed on the In-Sn-Si-O thin film, and the release of the water-derived components may be inhibited. When heat treatment is added immediately after the formation of the In-Sn-Si-O thin film, from the In-Sn-Si-O thin film, the water-derived components can be more efficiently released out of the film. Such water-derived components in the oxide thin film can be evaluated from a spectrum in the thermal desorption gas analysis method (TDS). In particular, a TDS spectrum due to the mass number 18 (that is, $H_2O$) in a spectrum region at 300°C or less is noted, and when the integrated intensity of the noted spectrum from the oxide thin film after the heat treatment decreases to one third or less of intensity before the heat treatment, good thin film transistor characteristics can be obtained. This heat treatment can be carried out in a temperature-controlled air atmosphere oven and may be performed under an atmosphere replaced by an oxidizing gas, such as oxygen.

Such heat treatment after the completion of the thin film transistor structure or immediately after the formation of the In-Sn-Si-O thin film allowed stably controlling the average carrier density in the In-Sn-Si-O thin film at $1 \times 10^{15}$

$cm^{-3}$ or more and $1 \times 10^{19}$ $cm^{-3}$ or less. When heat treatment was not performed, the carrier density in the In-Sn-Si-O film was about $1 \times 10^{20}$ $cm^{-3}$ in a certain portion on the substrate, and a thin film transistor that did not turn on/off was also formed. Specifically, when heat treatment was performed at 150°C for 1 hour, the carrier density in the In-Sn-Si-O film was about $5 \times 10^{18}$ $cm^{-3}$ in the entire region on the substrate, and when heat treatment was performed at 300°C for 1 hour, the carrier density in the In-Sn-Si-O film was about $3 \times 10^{17}$ $cm^{-3}$ in the entire region in the substrate.

Instead of performing such heat treatment, the substrate temperature during sputtering may be increased. Specifically, when film formation was performed at a substrate temperature of 150°C, the carrier density in the In-Sn-Si-O film was about $1 \times 10^{18}$ $cm^{-3}$ in the entire region in the substrate, and when film formation was performed at a substrate temperature of 300°C, the carrier density in the In-Sn-Si-O film was about $2 \times 10^{16}$ $cm^{-3}$ in the entire region on the substrate, and good thin film transistor characteristics were achieved.

In this Example, when the In-Sn-Si-O thin film was formed, the simultaneous sputtering method using an ITO target and a Si target was adopted. But, the film may be formed by previously fabricating an In-Sn-Si-O target and using this one In-Sn-Si-O target. In this case, it is important that the average atomic ratio of Si to In in the target is 0.1 or more and 0.4 or less, and the average atomic ratio of Sn to In is 0.03 or more and 0.5 or less, and also for the atomic ratio in the In-Sn-Si-O thin film formed with the target, the average atomic ratio of Si to In is 0.1 or more and 0.4 or less, and the average atomic ratio of Sn to In is 0.03 or more and 0.5 or less.

Example 2

The thin film transistor of Example 2 will be described with reference to Figure 1.

A glass substrate was used as an insulating substrate 10, and a film of Cr was formed on this substrate by a sputtering method. Then, patterning was performed using a photolithography technique and an etching technique to form a gate electrode 11 of a predetermined shape.

Then, a silicon oxide film (thickness: 200 nm) was formed as a gate insulating film 12 by a sputtering method.

Then, the substrate was conveyed to an adjacent chamber via a gate valve, and an In-Si-O thin film (thickness: 30 nm) was continuously formed by a sputtering method without exposure to the air, and then patterned in a predetermined shape to form an active layer 13 made of this oxide thin film. The film formation temperature was room temperature. As the sputtering target, a target with a composition represented by $In_{10}Si_2O_{19}$ was used. In other words, this target had a composition in which the average atomic ratio of Si to In was 0.2. In addition, the total gas pressure during the film formation was set at 0.5 Pa, and the flow rate ratio of argon gas to oxygen gas was set at 9:1. In other words, sputtering was performed under an atmosphere of a mixed gas of argon and oxygen with a gas pressure ratio (oxygen gas partial pressure/(argon gas partial pressure + oxygen gas partial pressure)) of 0.1. The composition ratio of the In-Si-O thin film formed in this manner approximately matches the composition ratio of the above target, and the carrier density in the thin film estimated in Hall effect measurement was on the order of $1 \times 10^{17}$ $cm^{-3}$. The composition ratio of the thin film was measured by the Rutherford backscattering method.

This In-Si-O thin film was patterned in a predetermined shape to form the active layer 13, and then, a Mo film was formed and patterned in a predetermined shape to form source-drain electrodes 14.

Then, a silicon oxide film was formed as a protective insulating film 15 by a room temperature sputtering method, and a predetermined contact hole was formed to complete a thin film transistor structure. In order to obtain stable electrical characteristics, finally, heat treatment was performed in the air atmosphere at 300°C for 1 hour.

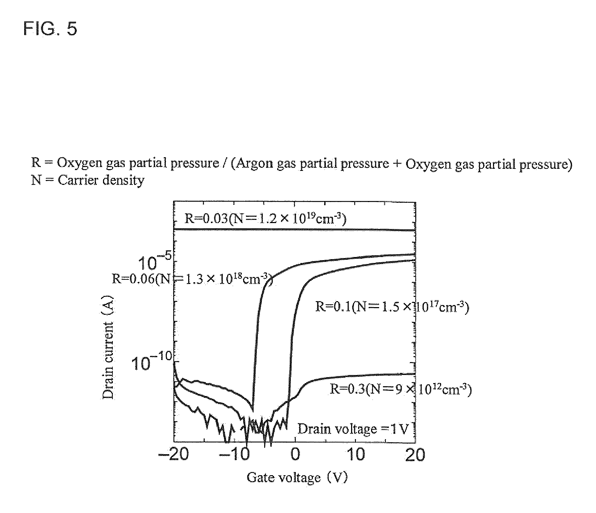

Figure 5 shows changes in thin film transistor characteristics when the above target ($In_{10}Si_2O_{19}$) is used and the conditions during sputtering are changed to change carrier density (electron density) in the In-Si-O thin film at room temperature. When the carrier density (N) exceeds $1 \times 10^{19}$ $cm^{-3}$, off characteristics are not shown. The gas pressure ratio (R) at this time is oxygen gas partial pressure/(argon gas partial pressure + oxygen gas partial pressure) = 0.03. When the carrier density is smaller than $1 \times 10^{15}$ $cm^{-3}$, on characteristics are not shown. The gas pressure ratio (R) at this time is oxygen gas partial pressure/(argon gas partial pressure + oxygen gas partial pressure) = 0.3. These experimental data show that it is important to control the average carrier density in the thin film at $1 \times 10^{15}$ $cm^{-3}$ or more and $1 \times 10^{19}$ $cm^{-3}$ or less. Here, in order to control the carrier density in the In-Si-O thin film at $1 \times 10^{15}$ $cm^{-3}$ or more and $1 \times 10^{19}$ $cm^{-3}$ or less, the gas pressure ratio (R) during sputtering was set to satisfy 0.05 < oxygen gas partial pressure/(argon gas partial pressure + oxygen gas partial pressure) < 0.25. The carrier density in the film when the gas pressure ratio (R) was 0.1 was $1.5 \times 10^{17}$ $cm^{-3}$, and good electrical characteristics with an on/off ratio of seven digits, a field-effect mobility of about 10 $cm^2V^{-1}s^{-1}$, and a threshold voltage of about 1 V were achieved.

In the above Example 2, the case of the In-Si-O thin film has been described, but it is also possible to use Sn, Ga, or Zn as an alternative to In. In addition, it is also possible to use Al, Ge, Ti, Mg, or Ta as an alternative to Si.

In Example 2, a silicon oxide film was used as the protective insulating film and the gate insulating film in contact with the In-Si-O thin film. When an oxide (silicon oxide in the case of this Example) of an element (silicon in the case of this Example) in an oxide thin film is used for the gate insulating film and the protective insulating film in this manner, defects can be reduced at respective interfaces, and better thin film transistor characteristics are obtained. For example, when an In-Al-O thin film is used for the active layer, aluminum oxide can be used as the gate insulating film and the protective insulating film. However, the gate insulating film and the protective insulating film are not limited in this manner, and according to the process, insulating films other than silicon oxide can be used with respect to an In-Si-O thin film, and silicon oxide and other insulating films can also be used with respect to an In-Al-O thin film.

In the above Example, heat treatment was performed after the completion of the thin film transistor structure, but it is also possible to add heat treatment during the manufacture of the thin film transistor, for example, immediately after the formation of the In-Si-O thin film. Particularly in the In-Si-O thin film formed by room temperature-sputtering, components derived from water (an OH group and the like) may be included. If such components are included, the electrical characteristics of the thin film transistor may be unstable. It is possible to release such water-derived components out of the film by performing heat treatment after the completion of the thin film transistor structure. But, after the completion of the thin film transistor structure, a thin film, such as the protective insulating film, is formed on the In-Si-O thin film, and the release of the water-derived components may be inhibited. When heat treatment is conducted immediately after the formation of the In-Si-O thin film, the water-derived components can be more efficiently released out of the In-Si-O thin film. This heat treatment can be carried out in a temperature-controlled air atmosphere oven and may be performed under an atmosphere replaced by an oxidizing gas, such as oxygen.

Such heat treatment after the completion of the thin film transistor structure or immediately after the formation of the In-Si-O thin film allowed stably controlling the average carrier density in the In-Si-O thin film at $1 \times 10^{15}$ cm$^{-3}$ or more and $1 \times 10^{19}$ cm$^{-3}$ or less. When heat treatment was not performed, the carrier density in the In-Si-O film was about $1 \times 10^{20}$ cm$^{-3}$ in a certain portion in the substrate, and a thin film transistor that did not turn on/off was also formed. Specifically, when heat treatment was performed at 150°C for 1 hour, the carrier density in the In-Si-O film was about $5 \times 10^{18}$ cm$^{-3}$ in the entire region on the substrate, and when heat treatment was performed at 300°C for 1 hour, the carrier density in the In-Si-O film was about $3 \times 10^{17}$ cm$^{-3}$ in the entire region on the substrate.

Instead of performing such heat treatment, the substrate temperature during sputtering may be increased. Specifically, when film formation was performed at a substrate temperature of 150°C, the carrier density in the In-Si-O film was about $1 \times 10^{18}$ cm$^{-3}$ in the entire region on the substrate, and when film formation was performed at a substrate temperature of 300°C, the carrier density in the In-Si-O film was about $2 \times 10^{16}$ cm$^{-3}$ in the entire region on the substrate, and good thin film transistor characteristics were achieved.

In the above Examples 1 and 2, the silicon oxide film formed by sputtering was used as the protective insulating film. In this film formation, the surface of the In-Sn-Si-O thin film or the In-Si-O thin film was exposed to a sputtering plasma. As a result, such a local defect occurred in some rare cases that the carrier density near the surface of the In-Sn-Si-O thin film or the In-Si-O thin film (that is, at the top side interface of the thin film transistor) exceeded $1 \times 10^{19}$ cm$^{-3}$. Such an unusual local increase in carrier density was not recovered even by subsequent heat treatment. This was because the surface was reduced by the plasma. Therefore, it is also possible to use, for the protective insulating film, first, a film formation method using no plasma, specifically, a method of forming a silicon oxide film by applying a solution of siloxane, silazane, or the like dissolved in an organic solvent and heat-treating the solution to evaporate the organic solvent. In such a film formation method, the surface of the In-Sn-Si-O thin film or the In-Si-O thin film is not exposed to a plasma, and the carrier density does not increase unusually. The silicon oxide film formed using such a solution tends to be porous, and the ability of the silicon oxide film to prevent external moisture intrusion tends to decrease. Therefore, it is desired to further form a silicon oxide film or a silicon nitride film on the silicon oxide film formed using the solution, by a plasma film formation method, such as sputtering, to provide a laminated protective insulating film. In the case of such a laminated protective insulating film, the flexibility in the selection of the insulating film stacked on the upper side widens. For example, in terms of the ability to prevent moisture intrusion, a silicon nitride film is preferred, but a problem of the silicon nitride film is that when the silicon nitride film is directly formed on the In-Sn-Si-O thin film or the In-Si-O thin film, the surface of the In-Sn-Si-O thin film or the In-Si-O thin film is reduced. On the other hand, when such a laminated protective insulating film is used, the silicon nitride film can be used as the protective insulating film without being in contact with the surface of the In-Sn-Si-O thin film or the In-Si-O thin film, and not only the silicon nitride film but other insulating films that are not oxide films can be used as the protective insulating film.

In the above Example 2, Mo was used as the material of the source-drain electrodes. Even a thin film made of such a metal can form a practical ohmic contact with the In-Sn-Si-O thin film or the In-Si-O thin film, but a thin film of a compound of indium oxide and tin oxide, the so-called ITO, easily forms a better ohmic contact with the Tn-Sn-Si-O thin film or the In-Si-O thin film. Therefore, when a metal is used for the material of the source-drain electrodes, it is desired to form a laminated structure such as metal/ITO and bring the ITO thin film of this laminated structure into direct contact with the In-Sn-Si-O thin film or the In-Si-O thin film. The use of such a laminated structure widens the options for the metal. For example, in a case where Al is used, when the In-Sn-Si-O thin film or the In-Si-O thin film is brought into direct contact with Al, an insulating aluminum oxide is formed at the interface, and an ohmic contact is not obtained. When a laminated structure such as Al/Mo/ITO or Al/Ti/ITO is used, there is no such a problem, and a good ohmic contact can be achieved. Moreover, lower resistance utilizing an advantage of Al can be achieved. Of course, by using a laminated structure such as Al/Mo or Al/Ti without using ITO, an ohmic contact can be formed between Mo or Ti and the In-Sn-Si-O thin film or the In-Si-O thin film. In particular, since an oxide of Ti is an electrical conductor, a good ohmic contact can be achieved even if Ti is oxidized at the Ti/ITO or Ti/In-(Sn)-Si-O interface. Further, when an Al-Si alloy including in Al a slight amount of Si at an atomic ratio of 1% to 5% is used for the source-drain electrodes, the resistivity is slightly higher than that for pure Al, but an ohmic contact is obtained by direct connection to the In-Sn-Si-O thin film or the In-Si-O thin film. This is because defects at the interface between the In-Sn-Si-O thin film or the In-Si-O thin film including Si and the Al-Si alloy similarly including Si are kept small.

In this Example, the oxide thin film was formed by sputtering using one target including three elements. On the other hand, film formation by a simultaneous sputtering method using a plurality of targets is also possible. For example, it is possible to form an In-Si-O thin film on a substrate by simultaneous sputtering using an $In_2O_3$ target and a Si target (or a $SiO_2$ target). At this time, by controlling the ratio of sputtering electric power applied to these two targets, the ratio of Si to In in the thin film can be 0.1 or more and 0.4 or less. In addition, at the same time, by setting the oxygen gas partial pressure/(argon gas partial pressure + oxygen gas partial pressure) ratio larger than 0.05 and smaller than 0.25, the carrier density can be $1 \times 10^{15}$ cm$^{-3}$ or more and $1 \times 10^{19}$ cm$^{-3}$ or less. In addition, similarly, In-Al-O thin film formation by simultaneous sputtering using an $In_2O_3$ target and Al (or an $Al_2O_3$ target) is also possible.

Example 3

The thin film transistor of Example 3 will be described with reference to Figure 2.

A glass substrate was used as an insulating substrate 10, and a film of Cr metal was formed on this substrate by a sputtering method. Then, patterning was performed using a photolithography technique and an etching technique to form source-drain electrodes 14 having a predetermined shape.

Then, an In-Al-O thin film (thickness: 30 nm) was formed by a sputtering method and then patterned in a predetermined shape to form an active layer 13 made of this oxide thin film. The film formation temperature was room temperature. As the sputtering target, a target with a composition represented by $In_{10}Al_2O_{18}$ was used. In other words, this target had a composition in which the average atomic ratio of Al to In was 0.2. In addition, the total gas pressure during the film formation was set at 0.5 Pa, and the flow rate ratio of argon gas to oxygen gas was set at 18:1. In other words, sputtering was performed under an atmosphere of a mixed gas of argon and oxygen with a gas pressure ratio (oxygen gas partial pressure/(argon gas partial pressure + oxygen gas partial pressure)) of 0.053. The composition ratio of the In-Al-O thin film formed in this manner approximately matches the above target composition ratio, and the carrier density in the thin film was on the order of $1 \times 10^{16}$ cm$^{-3}$.

This In-Al-O thin film was patterned in a predetermined shape to form the active layer 13, and then, an aluminum oxide film (thickness: 300 nm) was formed as a gate insulating film 12 by a sputtering method.

Then, a film of Mo was formed and patterned in a predetermined shape to form a gate electrode 11. Then, a silicon oxide film was formed as a protective insulating film 15 by a room temperature sputtering method, and a predetermined contact hole was formed to complete a thin film transistor structure. In order to obtain stable electrical characteristics, finally, heat treatment was performed in the air atmosphere at 300°C for 1 hour.

Such a thin film transistor achieved good electrical characteristics with an on/off ratio of six digits, a field-effect mobility of about 5 cm$^2$V$^{-1}$s$^{-1}$, and a threshold voltage of about 1 V.

In the above Example, heat treatment was performed after the completion of the thin film transistor structure, but it is also possible to conduct heat treatment during the manufacture of the thin film transistor, for example, immediately after the formation of the In-Al-O thin film. Particularly in the In-Al-O thin film formed by room temperature-sputtering, components derived from water (an OH group and the like) may be included, as in the case of the In-Si-O film. If such components are included, the electrical characteristics of the thin film transistor may be unstable. It is possible to release such water-derived components out of the film by performing heat treatment after the completion of the thin film transistor structure. But, after the completion of the thin film transistor structure, thin films, such as the gate insulating film and the protective insulating film, are formed on the In-Al-O thin film, and the release of the water-derived components may be inhibited. When heat treatment is conducted immediately after the formation of the In-Al-O thin film, the water-derived components can be more efficiently released out of the In-Al-O thin film. This heat treatment can be carried out in a temperature-controlled air atmosphere oven and may be performed under an atmosphere replaced by an oxidizing gas, such as oxygen.

Such heat treatment after the completion of the thin film transistor structure or immediately after the formation of the In-Al-O thin film allowed stably controlling the average carrier density in the In-Al-O thin film at $1 \times 10^{15}$ cm$^{-3}$ or more and $1 \times 10^{19}$ cm$^{-3}$ or less. When heat treatment was not performed, the carrier density in the In-Al-O film was about $2 \times 10^{20}$ cm$^{-3}$ in a certain portion in the substrate, and a thin film transistor that did not turn on/off was also formed. Specifically, when heat treatment was performed at 150°C for 1 hour, the carrier density in the In-Al-O film was about $7 \times 10^{18}$ cm$^{-3}$ in the entire region on the substrate, and when heat treatment was performed at 300°C for 1 hour, the carrier density in the In-Al-O film was about $6 \times 10^{17}$ cm$^{-3}$ in the entire region on the substrate.

Instead of performing such heat treatment, the substrate temperature during sputtering may be increased.

Specifically, when film formation was performed at a substrate temperature of 150°C, the carrier density in the In-Al-O film was about $3 \times 10^{18}$ cm$^{-3}$ in the entire region on the substrate, and when film formation was performed at a substrate temperature of 300°C, the carrier density in the In-Al-O film was about $5 \times 10^{16}$ cm$^{-3}$ in the entire region on the substrate, and good thin film transistor characteristics were achieved.

The oxide thin film in this Example includes three elements, In-Al-O, but even with an oxide thin film including four elements such as In-Sn-Al-O, good thin film transistor characteristics are obtained.

In this Example, the oxide thin film was sputtered using one target including three elements, but the oxide thin film can also be formed by a simultaneous sputtering method using a plurality of targets as was also possible in the case of the above-described In-Si-O thin film (Example 2).

In the above Example, Cr was used as the material of the source-drain electrodes. Even a thin film made of such a metal can form a practical ohmic contact with the In-Sn-Al-O thin film or the In-Al-O thin film, but a thin film of a compound of indium oxide and tin oxide, the so-called ITO, easily forms a better ohmic contact with the In-Sn-Al-O thin film or the In-Al-O thin film. Therefore, when a metal is used for the material of the source-drain electrodes, it is desired to form a laminated structure such as metal/ITO and bring the ITO thin film of this laminated structure into direct contact with the In-Sn-Al-O thin film or the In-Al-O thin film. The use of such a laminated structure widens the options for the metal. For example, in a case where Al is used, when the In-Sn-Al-O thin film or the In-Al-O thin film is brought into direct contact with Al, an insulating aluminum oxide is formed at the interface, and an ohmic contact is not obtained. When a laminated structure such as Al/Mo/ITO or Al/Ti/ITO is used, there is no such a problem, and a good ohmic contact can be achieved. Moreover, lower resistance utilizing an advantage of Al can be achieved. Of course, by using a laminated structure such as Al/Mo or Al/Ti without using ITO, an ohmic contact can be formed between Mo or Ti and the In-Sn-Al-O thin film or the In-Al-O thin film. In particular, since an oxide of Ti is an electrical conductor, a good ohmic contact can be achieved even if Ti is oxidized at the Ti/ITO or Ti/In-(Sn)-Al-O interface.

The thin film transistor of Example 3 had a top channel structure (top gate staggered type) in which a gate insulating film was formed on an In-Al-O (or In-Sn-Al-O) thin film, as shown in Figure 2. In this structure, a phenomenon was observed in rare cases in which when the gate insulating film was formed by sputtering, the surface of the thin film was affected by sputtering, and thus, the top channel side interface was reduced, and the carrier density was unusually high. Therefore, it is desired to form a silicon oxide film using a solution, and further form a silicon oxide film or a silicon nitride film thereon by a plasma film formation method, such as sputtering, to provide a laminated gate insulating film, as in the methods for forming the protective insulating film in the above-described Examples 1 and 2. In this structure, the protective insulating film is not in direct contact with the In-Al-O (or In-Sn-Al-O) thin film, and therefore, the film formation method and the material type are not restricted. The insulating film can be provided by the desired method. In addition, the insulating film is not limited to a silicon oxide film, and an insulating film (for example, a silicon nitride film) can be provided with the desired material other than oxide films.

In Example 3, an example of a thin film transistor of a top channel structure using an In-Al-O (or In-Sn-Al-O) thin film for the active layer has been described. Instead of this In-Al-O (or In-Sn-Al-O) thin film, an In-Sn-Si-O thin film or an In-Si-O thin film can be used.

As described above, in Examples 1 to 3, a sputtering method, which was a vacuum process, was used for the formation of the In-Si-O thin film (or the In-Sn-Si-O thin film) or the In-Al-O thin film (or the In-Sn-Al-O thin film). In order to further reduce the cost of the thin film transistor manufacturing process, it is desired to form these thin films using a film formation method according to the process of solidification from a solution state.

In this film formation method, a liquid including at least In, Si and O elements and an organic solvent is applied or printed on a substrate, and then, heat treatment is performed at a temperature of 150°C or more. Thus, an In-Si-O thin film with an average carrier density of $1 \times 10^{15}$ cm$^{-3}$ or more and $1 \times 10^{19}$ cm$^{-3}$ or less and a carbon density of $1 \times 10^{19}$ cm$^{-3}$ or less can be formed.

First, a solution of molecules including any one of In, Si, and O dissolved in a solvent, such as butyl acetate or xylene, was prepared. As the molecules including any one of In, Si, and O, indium chloride ($InCl_3$) and siloxane (including Si-OH) can be used. Here, for the atomic ratio in the solution, the average atomic ratio of Si to In was 0.1 or more and 0.4 or less.

Next, this solution was spin-coated at a rotation speed of about 3000 rpm, introduced into an oven set at an atmosphere temperature of 200°C within 1 minute from the spin coating, and solidified under the air atmosphere to form an In-Si-O thin film.

The carrier density of the In-Si-O thin film formed in this manner was on the order of $1 \times 10^{17}$ cm$^{-3}$, and the carbon density was on the order of $1 \times 10^{16}$ cm$^{-3}$, achieving good electrical characteristics similar to those of the thin film transistors fabricated by sputtering. In such a film formation method, a method of directly drawing an In-Si-O thin film of the desired pattern shape by an ink-jet method can also be used.

In this film formation method, it is important that the carbon density in the oxide thin film is $1 \times 10^{19}$ cm$^{-3}$ or less. For example, when the carbon density was $5 \times 10^{18}$ cm$^{-3}$, a thin film transistor with an on/off ratio of six digits and a field-effect mobility of about 4 cm$^2$V$^{-1}$s$^{-1}$ was obtained. But, when the carbon density increased to $2 \times 10^{19}$ cm$^{-3}$,

significant decreases in characteristics, an on/off ratio of three digits and a field-effect mobility of 0.02 $cm^2V^{-1}s^{-1}$, were seen.

In addition, in this film formation method, the following treatment is important. After the raw material solution is spin-coated or ink-jet-printed, it is quickly (for example, within 2 minutes) transferred to an atmosphere at 150°C or more in which oxygen is present (for example, an oven with the air atmosphere set at 150°C or more). By solidifying the film of the raw material liquid by such a treatment to form an oxide thin film, carbon in the film was released out of the film as carbon dioxide, and the residual carbon density in the film was $1 \times 10^{19}$ $cm^{-3}$ or less.

In the above example, the method for forming an In-Si-O thin film has been described. It is also possible to form an In-Al-O thin film by a similar method using a solution of molecules including at least any one of In, Al and O dissolved in a solvent, such as butyl acetate. As the molecules including any one of In, Al and O, indium chloride ($InCl_3$), aluminum chloride ($AlCl_3$), and aluminate (including Al-OH) can be used. A solution including three compounds, indium chloride, aluminum chloride, and aluminate, may be used, or a solution including two compounds, indium chloride and aluminate, may be used.

Industrial Applicability

The exemplary embodiments can be used for pixel driving elements of flat panel displays, such as liquid crystal displays, organic EL displays, and electronic paper. In particular, the element composition ratio and carrier density of the oxide semiconductor thin films are controlled in the exemplary embodiments, and therefore, thin film transistors with more precisely controlled electrical characteristics, such as threshold voltage, are obtained. Accordingly, the exemplary embodiments can be used not only for pixel driving elements but also for higher performance circuits such as logic circuits based on inverters.

In addition, the exemplary embodiments can provide oxide semiconductor thin films with an electron mobility higher by about one digit than that of a typical amorphous silicon film formed at 300°C, even when the films are formed at room temperature, and therefore, thin film transistor arrays with good characteristics can be formed even by room temperature film formation. Accordingly, good characteristics are obtained even on resin substrates with low heat resistance, and hence, the exemplary embodiments can also be applied to flexible resin substrate displays.

While the present invention has been described with reference to the exemplary embodiments, the present invention is not limited to the above embodiments. Various changes that can be understood by those skilled in the art may be made to the constitution and details of the present invention within the scope thereof.

This application claims the right of priority based on Japanese Patent Application No. 2010-020528 filled on February 1, 2010, the entire content of which is incorporated herein by reference.

Reference Signs List

10 insulating substrate
11 gate electrode
12 gate insulating film
13 oxide thin film
14 source-drain electrodes
15 protective insulating film

**Claims**

1. A thin film transistor using an amorphous oxide thin film for an active layer,
   wherein the amorphous oxide thin film comprises, as main components,
   indium (In),
   oxygen (O), and
   a metal element (M) selected from the group consisting of silicon (Si), aluminum (Al), germanium (Ge), tantalum (Ta), magnesium (Mg) and titanium (Ti);
   an atomic ratio of M to In in the amorphous oxide thin film is 0.1 or more and 0.4 or less; and
   carrier density in the amorphous oxide thin film is $1 \times 10$ $cm^{-3}$ or more and $1 \times 10^{19}$ $cm^{-3}$ or less.

2. The thin film transistor according to claim 1, wherein the metal element (M) is Si or Al.

3. The thin film transistor according to claim 1 or 2, wherein the amorphous oxide thin film further comprises tin (Sn), and an atomic ratio of Sn to In in the amorphous oxide thin film is 0.03 or more and 0.5 or less.

4. The thin film transistor according to any one of claims 1 to 3, wherein the thin film transistor comprises a gate insulating film in contact with the amorphous oxide thin film,
the metal element (M) is Si or Al,
when M is Si, the gate insulating film is a silicon oxide film, and
when M is Al, the gate insulating film is an aluminum oxide film.

5. An amorphous oxide thin film comprising, as main components, indium (In), oxygen (O), and a metal element (M) selected from the group consisting of silicon (Si), aluminum (Al), germanium (Ge), tantalum (Ta), magnesium (Mg) and titanium (Ti),
wherein an atomic ratio of M to In is 0.1 or more and 0.4 or less, and
carrier density is $1 \times 10^{15}$ cm$^{-3}$ or more and $1 \times 10^{19}$ cm$^{-3}$ or less.

6. The amorphous oxide thin film according to claim 5, wherein the amorphous oxide thin film further comprises tin (Sn), and
an atomic ratio of Sn to In in the amorphous oxide thin film is 0.03 or more and 0.5 or less.

7. A method for manufacturing a thin film transistor of claim 1, the method comprising performing sputtering under an atmosphere of a mixed gas comprising a noble gas and oxygen, satisfying the following conditional formula of a gas pressure ratio:

$$0.05 < \text{oxygen gas partial pressure/(noble gas partial pressure} + \text{oxygen gas partial pressure)} < 0.25,$$

to form the amorphous oxide thin film.

8. A method for manufacturing a thin film transistor of claim 3, the method comprising performing sputtering under an atmosphere of a mixed gas comprising a noble gas and oxygen, satisfying the following conditional formula of a gas pressure ratio:

$$0.05 < \text{oxygen gas partial pressure/(noble gas partial pressure} + \text{oxygen gas partial pressure)} < 0.25,$$

to form the amorphous oxide thin film.

9. The method for manufacturing a thin film transistor according to claim 7 or 8, wherein the sputtering is performed at a substrate temperature of 150°C or more in the formation of the amorphous oxide thin film, or
the sputtering is performed at a substrate temperature less than 150°C in the formation of the amorphous oxide thin film and then heat treatment is performed at 150°C or more.

10. A method for manufacturing a thin film transistor of claim 1, the method comprising:

applying or printing a liquid comprising In, the metal element (M) and O on a substrate, and
performing heat treatment at 150°C or more, such that carbon density is $1 \times 10^{19}$ cm$^{-3}$ or less, to solidify the liquid to form the amorphous oxide thin film.

FIG. 1

14 Source/drain electrode
13 Oxide thin film
15 Protective insulating film
12 Gate insulating film
11 Gate electrode
10 Insulating substrate

FIG. 2

FIG. 3

FIG. 4

FIG. 5

R = Oxygen gas partial pressure / (Argon gas partial pressure + Oxygen gas partial pressure)
N = Carrier density

<table>
<tr><td colspan="2" align="center">**INTERNATIONAL SEARCH REPORT**</td><td>International application No.<br>PCT/JP2011/052016</td></tr>
</table>

| A. CLASSIFICATION OF SUBJECT MATTER |
|---|
| $H01L29/786$(2006.01)i, $C23C14/08$(2006.01)i, $C23C14/34$(2006.01)i, $H01L21/363$(2006.01)i, $H01L21/368$(2006.01)i |

According to International Patent Classification (IPC) or to both national classification and IPC

| B. FIELDS SEARCHED |
|---|
| Minimum documentation searched (classification system followed by classification symbols)<br>H01L29/786, C23C14/08, C23C14/34, H01L21/363, H01L21/368 |

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

| C. DOCUMENTS CONSIDERED TO BE RELEVANT |

| Category* | Citation of document, with indication, where appropriate, of the relevant passages | Relevant to claim No. |
|---|---|---|
| X<br>Y | JP 2009-147069 A (Canon Inc.),<br>02 July 2009 (02.07.2009),<br>entire text<br>& US 2010/0224870 A  & WO 2009/075242 A1 | 1-9<br>10 |
| X<br>Y | JP 2009-081413 A (Canon Inc.),<br>16 April 2009 (16.04.2009),<br>entire text<br>& US 2010/0258794 A  & EP 2193547 A<br>& WO 2009/031634 A1 | 1-9<br>10 |
| Y | JP 2010-010549 A (Konica Minolta Holdings, Inc.),<br>14 January 2010 (14.01.2010),<br>paragraphs [0011], [0018] to [0051], [0104] to [0106]<br>(Family: none) | 10 |

☐ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>14 April, 2011 (14.04.11) | Date of mailing of the international search report<br>26 April, 2011 (26.04.11) |
|---|---|
| Name and mailing address of the ISA/<br>Japanese Patent Office | Authorized officer |
| Facsimile No. | Telephone No. |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007073705 A

- JP 2010020528 A

**Non-patent literature cited in the description**

- **NOMURA et al.** *Nature,* 2004, vol. 432, 488
- **OGO et al.** *physica status solidi (a,* 2008, vol. 205, 1920
- **CHO et al.** International Display Workshops 2008. *Technical Digest,* 2008, 1625

- **CHIANG et al.** *Applied Physics Letters,* 2005, vol. 86, 013503
- **GOYAL et al.** *Materials Research Society Symposium Proceeding,* 2009, vol. 1109, B04-03